Europäisches Patentamt

European Patent Office

Office européen des brevets

(11) Veröffentlichungsnummer: **0 075 154**
**B1**

# (12) EUROPÄISCHE PATENTSCHRIFT

(45) Veröffentlichungstag der Patentschrift:
12.08.87

(21) Anmeldenummer: 82108080.1

(22) Anmeldetag: 02.09.82

(51) Int. Cl.⁴: **H 01 L 23/42,** H 01 L 23/46, H 01 L 25/16

(54) Leistungshalbleiterbauelement für Siedekühlung oder Flüssigkeitskühlung.

(30) Priorität: 19.09.81 DE 3137406

(43) Veröffentlichungstag der Anmeldung:
30.03.83 Patentblatt 83/13

(45) Bekanntmachung des Hinweises auf die Patenterteilung:
12.08.87 Patentblatt 87/33

(84) Benannte Vertragsstaaten:
CH DE FR IT LI SE

(56) Entgegenhaltungen:
DE-A-2 705 476
DE-A-3 007 382
FR-A-1 195 186

(73) Patentinhaber: BBC Aktiengesellschaft Brown, Boveri & Cie., Haselstrasse, CH- 5401 Baden (CH)

(72) Erfinder: Klein, Erwin, Dresdener Strasse 5, D-6805 Heddesheim (DE)

(74) Vertreter: Kempe, Wolfgang, Dr., c/o BROWN, BOVERI & CIE AG ZPT Postfach 351, D-6800 Mannheim 31 (DE)

## Beschreibung

Die Erfindung bezieht sich auf ein Leistungshalbleiterbauelement für Siedekühlung oder Flüssigkeitskühlung gemäß dem Oberbegriff des Anspruches 1.

Ein solches Leistungshalbleiterbauelement für Siedekühlung oder Flüssigkeitskühlung ist aus DE-A-29 38 096 bekannt. Dort sind die Hauptelektroden mit ausschließlich zur Stromführung dienenden, die Gehäuseaußenwandung durchstoßenden elektrischen Multikontakten verbunden, um die Halbleiterkristallscheibe mechanisch und thermisch weitestgehend zu entlasten.

Halbleiterelemente auf der Basis von Silizium müssen mit Trägerstaueffekt-Beschaltungen versehen sein. Werden mehrere solcher Halbleiterelemente elektrisch in Reihe geschaltet, benötigen sie auch noch eine Beschaltung zur elektrischen Spannungsaufteilung.

Die Widerstände dieser elektrischen Beschaltungen weisen besonders beim Einsatz der Leistungshalbleiterbauelemente für höherfrequente Wechselrichter erhebliche Verlustleistungen auf, woraus große Bauabmessungen bei Luftkühlung der Beschaltungen resultieren. Bei Flüssigkeitskühlung der Beschaltungen sind zwar die Bauabmessungen geringer, jedoch ist dafür der Aufwand (Kosten) größer.

Der Erfindung liegt die Aufgabe zugrunde, bei einem Leistungshalbleiterbauelement für Siedekühlung oder Flüssigkeitskühlung der eingangs genannten Art eine einfache und kostengünstige Einbaumöglichkeit für eine notwendige elektrische Schaltung anzugeben.

Diese Aufgabe wird durch die im Anspruch 1 gekennzeichneten Merkmale gelöst.

Die mit der Erfindung erzielbaren Vorteile bestehen insbesondere darin, daß die in der elektrischen Beschaltung während des Betriebes entstehende Verlustwärme über die Kühleinrichtung des Leistungshalbleiterbauelementes selbst abgeführt werden kann. Es ist vorteilhaft keine zusätzliche Kühleinrichtung notwendig. Durch die intensive Kühlwirkung der Siedekühlung bzw. Flüssigkeitskühlung können die elektrischen Bauteile der Beschaltung gering und damit kostengünstig dimensioniert werden.

Vorteilhafte Ausgestaltungen der Erfindung sind in den Unteransprüchen gekennzeichnet.

Die Erfindung wird nachstehend anhand des in den Zeichnungen dargestellten Ausführungsbeispieles erläutert.

Es zeigen:

Fig. 1 das Leistungshalbleiterbauelement mit einem integrierten Beschaltungsmodul im geschnittenem Aufriß,

Fig. 2 das Leistungshalbleiterbauelement in teils geschnittenem Grundriß,

Fig. 3 ein elektrisches Beschaltungsmodul.

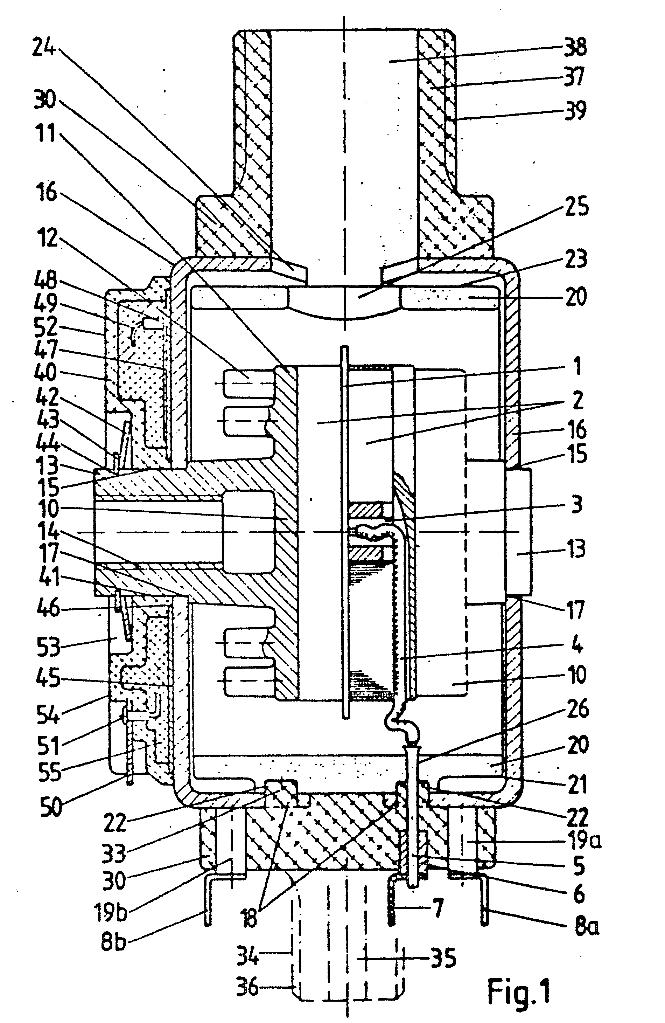

In Fig. 1 ist das Leistungshalbleiterbauelement für Siedekühlung mit einem integrierten Beschaltungsmodul in geschnittenem Aufriß dargestellt. Eine im Inneren des Leistungshalbleiterbauelementes befindliche Halbleiterkristallscheibe 1 ist über Multikontakte 2 (Multifederkontakte) beidseitig mittels stoffschlüssiger Verbindungen (Lötung) mit Kühlkörpern 10 verbunden. Jeder der beiden Kühlkörper 10 besteht aus einem Boden 11, der zur Vergrößerung der Oberfläche Kühlzapfen 12 trägt. Für den elektrischen Anschluß des Halbleiterbauelements ist an jedem Kühlkörper 10 zentrisch ein Anschlußauge 13 mit Innengewinde 14 angeformt, wobei das Anschlußauge 13 außen mit einer Andrehung 15 versehen ist. Auf jeder dieser Andrehungen 15 ist ein topfähnlicher metallener Deckel 16 über seine zentrale Bohrung 17 stoffschlüssig befestigt.

Bevor die einzelnen Bauteile Halbleiterkristallscheibe 1, Multikontakt 2, Kühlkörper 10 und Deckel 16 des Leistungshalbleiterbauelementes miteinander verbunden werden, wird zwischen die beiden Deckel 16 eine Keramikhülse 20 eingelegt. Diese Hülse 20 ist beidseitig mit äußeren Andrehungen 21, mehreren kleineren Grundbohrungen 22, einer Abflachung 23 und zwei größeren Bohrungen 25 versehen (es ist lediglich eine Bohrung 25 dargestellt).

Diese so zusammengebaute Baugruppe wird mit einer Isolierhülse 30 (aus Isoliermasse) umpreßt. Dabei dient die Keramikhülse 20 als verlorene Form. Die Isolierhülse 30 schafft die notwendige äußere elektrische Isolation des Leistungshalbleiterbauelementes. Außerdem stellt die Isolierhülse 30 die mechanische Verbindung zwischen den metallenen Deckel 16 her, so daß vorteilhaft eine Zugentlastung der stoffschlüssigen Verbindungsstellen vorliegt. Zu diesem Zweck sind die metallenen Deckeln 16 mit Bohrungen 18 und die Keramikhülsen 20 mit den Grundbohrungen 22 versehen, in die sich die Isoliermasse der Isolierhülse 30 während des Preßvorganges mit Noppen 33 verankert. An der Isolierhülse 30 ist ein Stutzen 34 mit zentraler Bohrung 35 (für den Kältemittelzulauf) und Gewinde 36 sowie diametral gegenüberliegend ein Stutzen 37 mit Bohrung 38 (für den Kältemittelablauf) und Außengewinde 39 angeformt. Diese Stutzen 34, 37 dienen wie oben erwähnt der Zu- bzw. Abfuhr von flüssigem bzw. gasförmigem Kühlmittel. Damit das gasförmige Kühlmittel ungehindert in die Bohrung 38 übertreten kann, sind die metallenen Deckel 16 mit teilkreisförmigen Ausschnitten 24 versehen.

Zur Ausbildung des Leistungshalbleiterbauelementes geschilderter Bauart als Thyristor wird eine Gate-Anschlußleitung 4 durch eine Bohrung 3 des Multikontaktes 2 zur Kontaktierung mit der Halbleiterkristallscheibe 1 geführt. Der externe Gate-Anschluß erfolgt mittels eines Anschlußstiftes 5, welcher in einer Bohrung 26 der Keramikhülse 20 fixiert ist. Der Anschlußstift 5 ist mittels einer Büchse 6 in der Isolierhülse 30 verankert. Am äußeren ende des Anschlußstiftes 5 ist ein Flachstecker 7 befestigt. Ein Hilfs-Kathodenanschluß des Thyristors erfolgt über einen metallenen Bolzen 19a, der am kathodenseitigen metallenen Deckel·16 des Halbleiterbauelementes angeschweißt ist und einen externen Flachstecker 8a trägt. Ein Hilfs-Anodenanschluß erfolgt in gleicher Weise über einen metallenen Bolzen 19b, der am anodenseitigen metallenen Deckel 16 angeschweißt ist und einen externen Flachstecker 8b trägt.

Mit dem Leistungshalbleiterbauelement ist ein elektrisches Beschaltungsmodul 40 integriert. Das Beschaltungsmodul 40 hat die Form eines flachen Zylinders und besitzt eine Mittelbohrung 41. Zur Montage wird das Beschaltungsmodul 40 mit seiner Mittelbohrung 41 auf die Andrehung 15 des Anschlußauges 13 gedrückt. Zur kraftschlüssigen thermischen Kontaktierung des Beschaltungsmoduls 40 auf dem mit Kühlflüssigkeit beaufschlagten metallenen Deckel 16 wird anschließend eine Feder 42 auf das Anschlußauge 13 gedrückt, die mittels eines Sicherungsringes 43 fixiert wird. Auf diese Weise kann die im Beschaltungsmodul entstehende Verlustwärme in die Kühlflüssigkeit abgeleitet werden. Der Sicherungsring 43 greift in eine Nut 44 des Anschlußauges 13 ein.

Das Beschaltungsmodul besteht aus einem kreisscheibenförmigen Keramiksubstrat 45, welches eine Mittelbohrung 46 aufweist. Auf dem Keramiksubtrat 45 sind mittels Dünn- oder Dickfilmtechnik oder auch in Form von metallenen Folien Widerstände 47 aufgebracht. Eventuell für die Beschaltung notwendige Dioden sind ohne Gehäuse mittels Klebung auf dem Keramiksubstrat 45 befestigt (nicht dargestellt). Für die elektrischen Anschlüsse dieser Beschaltungselemente sind Lötstifte 48 vorgesehen. Diese sind über Schaltdrähte 49 mit den externen Anschlüssen, welche als Flachstecker 50 vorliegen, und mittels Nieten 51 am Kunststoffgehäuse 52 befestigt sind, elektrisch verbunden.

Das Beschaltungmodul 40 wird abgedeckt eines Kunststoffgehäuses 52, welches die bereits erwähnte Bohrung 41 und eine topfförmige Einsenkung 53 aufweist. Die topfförmige Einsenkung 53 dient zur Aufnahme der Feder 42 sowie des Sicherungsringes 43. Durch entsprechende Verrippungen 54 am Kunststoffgehäuse 52 werden die erforderlichen elektrischen Kriech- und Luftstrecken zwischen den verschiedenen elektrischen Potentialen am Anschlußauge 13 bzw. Deckel 16 und den Flachstecker-Anschlüssen 50 hergestellt.

Nach der Montage der einzelnen Teile wird zwischen Gehäuse 52 und Substrat 45 über eine nicht dargestellte Bohrung im Kunststoffgehäuse 52 ein hochtemperaturfester Füllstoff 55, z.B. Siliconharz, gespritzt, der sicherstellt, daß die über das Gehäuse 52 von der·Feder 42 aufgebrachte Kraft gleichmäßig auf das Substrat 45 zur einwandfreien thermischen Kontaktierung mit dem metallenen Deckel 16 übertragen und verteilt wird.

Die elektrischen Anschlüsse vom Beschaltungsmodul 40 zur Anode und Kathode des Leistungshalbleiterbauelementes erfolgen über nicht dargestellte Leitungen zu den Flachsteckeranschlüssen 8a, 8b, die über die metallenen Bolzen 19a, 19b Kontakt mit den Deckeln 16 haben.

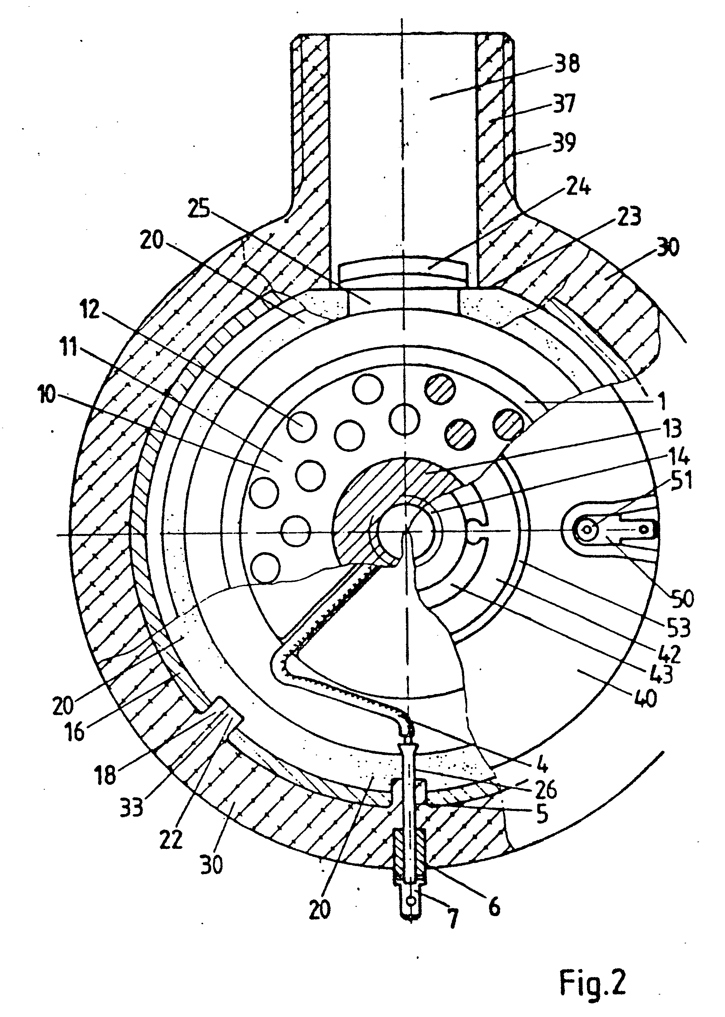

In Fig. 2 ist das Leistungshalbleiterbauelement in teils geschnittenem Grundriß dargestellt. Im einzelnen ist hieraus der radiale Aufbau des Elementes mit zentraler Halbleiterkristallscheibe 1, sich darauf befindendem Kühlkörper 10 (mit Boden 11 und Kühlzapfen 12), mit sich nach außen zu anschließender Keramikhülse 20, metallenem Deckel 16 und Isolierhülse 30 ersichtlich.

Zu erkennen sind ferner die Verankerungen zwischen Keramikhülse 20 und Isolierhülse 30 mittels der Noppen 33, die durch die Bohrungen 18 der metallenen Deckeln 16 in die Grundbohrung 22 der Keramikhülse 20 eingreifen.

Desweiteren ist der Gate-Anschluß über den mittels der Büchse 6 in der Isolierhülse 30 verankerten, sowie durch eine Bohrung im metallenen Deckel 16 und die Bohrung 26 durch die Keramikhülse 20 geführten·Anschlußstift 5 ersichtlich, wobei der Anschlußstift 5 extern mit dem Flachstecker 7 und intern mit der Gate-Anschlußleitung 4 verbunden ist.  ·

In Fig. 2 sind ferner das Anschlußauge 13·mit Innengewinde 14 zum elektrischen Anschluß des Leistungshalbleiterelementes sowie der Kältemittelablauf über den Stutzen 37 mit Außengewinde 39 der Isolierhülse 30 dargestellt. Der Kühlmittelablauf erfolgt über die Bohrung 25 in der Keramikhülse 20 am Ort der Abflachung 23, weiter über den teilkreisförmigen Ausschnitt 24 der metallenen Deckel 16 durch die Bohrung 38 des Stutzens 37.

Schließlich ist das Beschaltungsmodul 40 mit Sicherungsring 43, Feder 42, topfförmiger Einsenkung 53, Flachstecker 50 und Niete 51 dargestellt.

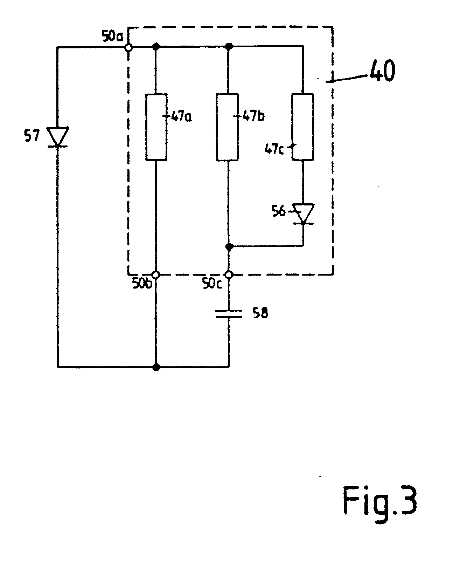

In Fig. 3 ist der elektrische Aufbau eines Beschaltungsmoduls 40, speziell eines Widerstands-Dioden-Moduls, dargestellt. Das Beschaltungsmodul 40 weist drei parallel geschaltete Widerstände 47a, 47b, 47c (z.B. in Dünn- oder Dickfilmtechnik) auf. Die Reihenschaltung aus dem Widerstand 47c und einer ebenfalls im Modul selbst eingebauten Sperrdiode 56 liegt dem Widerstand 47b parallel. Der Widerstand 47a liegt dem beschriebenen Leistungshalbleiterbauelement, einem Thyristor 57, parallel. Ferner liegt dem Thyristor 57 die Reihenschaltung aus dem Widerstand 47b und einem Kondensator 58 parallel. Während die Widerstände 47a, 47b, 47c und die Sperrdiode 56 Bestandteil des mit dem Leistungshalbleiterbauelements integrierten Beschaltungsmoduls 40 sind, wird der Kondensator 58 extern angebracht. Dieses spezielle Beschaltungsmodul 40 ist mit drei Flachsteckern 50a, 50b, 50c ausgerüstet, wobei Flachstecker 50a mit der Anode, Flachstecker 50b mit der Kathode und Flachstecker 50c mit dem Kondensator 58 verbunden sind.

Verschiedene Ausführungsformen der Multikontakte 2 sind aus der bereits erwähnten DE-A-29 38 096 sowie aus der DE-A- 28 55 493 und der DE-A-29 37 049 bekannt.

**Patentansprüche**

1. Leistungshalbleiterbauelement für Siedekühlung oder Flüssigkeitskühlung mit einer zwei Hauptelektroden und gegebenenfalls eine oder mehrere Steuerelektroden aufweisenden Halbleiterkristallscheibe, die in einem von einem elektrisch isolierenden Kühlmittel durchströmbaren flüssigkeits- und gasdichten Gehäuse eingebaut ist, wobei das Gehäuse im wesentlichen aus einer Keramikhülse mit beidseitig aufgesetzten metallenen Deckeln besteht und die metallenen Deckeln mit dem Kühlmittel direkt beaufschlagt sind, dadurch gekennzeichnet, daß elektrische Beschaltungen, insbesondere Widerstände und Dioden, in einem mit dem metallenen Deckel (16) des Leistungshalbleiterbauelementes kraftschlüssig thermisch kontaktiertem Beschaltungsmodul (40) integriert sind.

2. Leistungshalbleiterbauelement nach Anspruch 1, dadurch gekennzeichnet, daß das Beschaltungsmodul (40) aus einem Keramiksubstrat (45) als thermisch kontaktierbarem Boden und einem aufgesetzten Kunststoffgehäuse (52) besteht.

3. Leistungshalbleiterbauelement nach Anspruch 2, dadurch gekennzeichnet, daß auf dem Keramiksubstrat (45) Widerstände (47) in Dünnfilmtechnik aufgebracht sind.

4. Leistungshalbleiterbauelement nach Anspruch 2, dadurch gekennzeichnet, daß auf dem Keramiksubstrat (45) Widerstände (47) in Dickfilmtechnik aufgebracht sind.

5. Leistungshalbleiterbauelement nach Anspruch 2, dadurch gekennzeichnet, daß auf dem Keramiksubstrat (45) Widerstände (47) in Form von metallischen Folien aufgebracht sind.

6. Leistungshalbleiterbauelement nach Anspruch 2 und folgenden, dadurch gekennzeichnet, daß auf dem Keramiksubstrat (45) eine Diode befestigt ist.

7. Leistungshalbleiterbauelement nach Anspruch 2 und folgenden, dadurch gekennzeichnet, daß das Keramiksubstrat (45) mit Lötstiften (48) sowie das Kunststoffgehäuse (52) mit angenieteten Flachsteckern (50) für externe elektrische Anschlüsse versehen ist.

8. Leistungshalbleiterbauelement nach einem der vorstehenden Ansprüche, dadurch gekennzeichnet, daß das Beschaltungsmodul (40) eine Mittelbohrung (41) zum Aufstecken auf ein Anschlußauge (13) des Leistungshalbleiterbauelementes aufweist.

9. Leistungshalbleiterbauelement nach Anspruch 8, dadurch gekennzeichnet, daß das Kunststoffgehäuse (52) des Beschaltungsmoduls (40) eine topfförmige Einsenkung (53) zur Aufnahme einer Feder (42) und eines Sicherungsringes (43) aufweist.

10. Leistungshalbleiterbauelement nach Anspruch 9, dadurch gekennzeichnet, daß das Anschlußauge (13) eine Nut (44) zur Aufnahme des Sicherungsringes (43) aufweist.

**Claims**

1. Power semiconductor component for boiling-water cooling or liquid cooling, comprising a semiconductor crystal disc having two main electrodes and possibly one or more control electrodes, which is installed in a liquid- and gas-tight housing through which an electrically insulating coolant can flow, the housing essentially consisting of a ceramic shell with metal covers placed on it on both sides and the coolant being directly applied to the metal covers, characterized in that electric circuit elements, particularly resistors and diodes, are integrated in a circuit element module (40) which is frictionally connected in thermal contact with the metal cover (16) of the power semiconductor component.

2. Power semiconductor component according to Claim 1, characterized in that the circuit element module (40) consists of a ceramic substrate (45) as thermally contactable bottom and of a plastic housing (52) placed thereon.

3. Power semiconductor component according to Claim 2, characterized in that resistors (47) are applied to the ceramic substrate (45) in thin-film technique.

4. Power semiconductor component according to Claim 2, characterized in that resistors (47) are applied to the ceramic substrate (45) in thick-film technique.

5. Power semiconductor component according to Claim 2, characterized in that resistors (47) are applied to the ceramic substrate (45) in the form of metal foils.

6. Power semiconductor component according to Claim 2 and subsequent claims, characterized in that a diode is attached to the ceramic substrate (45).

7. Power semiconductor component according to Claim 2 and subsequent claims, characterized in that the ceramic substrate (45) is provided with soldering pins (48) and the plastic housing (52) is provided with riveted-on flat connectors (50) for external electric connections.

8. Power semiconductor component according to one of the preceding claims, characterized in that the circuit element module (40) has a centre hole (41) for plugging it onto a connecting eye (13) of the power semiconductor component.

9. Power semiconductor component according to Claim 8, characterized in that the plastic housing (52) of the circuit element module (40) has a pot-shaped indentation (53) for receiving a spring (42) and a retaining ring (43).

10. Power semiconductor component according to Claim 9, characterized in that the connecting eye (13) has a groove (44) for receiving the retaining ring (43).


**Revendications**

1. Composant semiconducteur de puissance à refroidissement par vaporisation ou par liquide, comportant une plaque de semiconducteur cristallin qui présente deux électrodes principales et éventuellement une ou plusieurs électrodes de commande et qui est montée dans un boîtier étanche aux liquides et aux gaz, apte à être parcouru par un réfrigérant électriquement isolant, ce boîtier étant constitué, pour l'essentiel, par un manchon en céramique avec des couvercles métalliques disposés des deux côtés, ces couvercles métalliques étant directement exposés au réfrigérant, caractérisé par le fait que des organes d'équipement, notamment des résistances et diodes, sont intégrés dans un module d'équipement (40) qui, par serrage, est en contact thermique avec le couvercle métallique (16) du composant semiconducteur de puissance.

2. Composant semiconducteur de puissance selon revendication 1, caractérisé par le fait que le module d'équipement (40) est constitué par un substrat en céramique (45) en tant que fond apte au contact thermique, et par un boîtier en matière plastique (52) placé sur celui-ci.

3. Composant semiconducteur de puissance selon revendication 2, caractérisé par le fait que des résistances (47) sont appliquées, en technique à couche mince, sur le substrat en céramique (45).

4. Composant semiconducteur de puissance selon revendication 2, caractérisé par le fait que des résistances (47) sont appliquées, en technique à couche épaisse, sur le substrat en céramique (45).

5. Composant semiconducteur de puissance selon revendication 2, caractérisé par le fait que des résistances (47) sous forme de feuilles métalliques sont appliquées sur le substrat en céramique (45).

6. Composant semiconducteur de puissance selon revendication 2 et suivantes, caractérisé par le fait qu'une diode est fixée sur le substrat en céramique (45).

7. Composant semiconducteur de puissance selon revendication 2 et suivantes, caractérisé par le fait que le substrat en céramique (45) est muni de broches pour soudage (48) et que le boîtier en matière plastique (52) est muni de connecteurs plats (50) fixés par rivetage, pour connexions électriques externes.

8. Composant semiconducteur de puissance selon l'une quelconque des revendications précédentes, caractérisé par le fait que le module d'équipement (40) présente un trou central (41) pour emboîtement sur un embout de connexion (13) du composant semiconducteur de puissance.

9. Composant semiconducteur de puissance selon revendication 8, caractérisé par le fait que le boîtier en matière plastique (52) du module d'équipement (40) présente une dépression (53) pour recevoir un ressort (42) et un anneau d'arrêt (43).

10. Composant semiconducteur de puissance selon revendication 9, caractérisé par le fait que l'embout de connexion (13) présente une gorge (44) pour recevoir l'anneau d'arrêt (43).

Fig.1

0 075 154

Fig.2

Fig.3